# EUROPEAN PATENT APPLICATION

(11) **EP 2 187 521 A2**
(43) Date of publication of application: **19.05.2010**
(21) Application number: 09176214.6
(22) Date of filing: 17.11.2009
(51) Int. Cl.: H03K 3/543

(54) **Pulse generating circuit**

(30) Priority: 18.11.2008 JP 2008293992; 03.11.2009 JP 2009252499
(71) Applicant: Kabushiki Kaisha Toyota Jidoshokki, Kariya-shi, Aichi 448-8671 (JP)
(72) Inventor: Kawauchi, Hiroyasu, Kariya-shi Aichi 448-8671 (JP); Kobayashi, Mitsugu, Kariya-shi Aichi 448-8671 (JP); Yoshida, Toshihiko, Kariya-shi Aichi 448-8671 (JP)
(74) Representative: TBK-Patent

(57) **Abstract**

A high-voltage pulse generating circuit includes a direct current power source, a transformer, a switching device and a switching control circuit. The transformer includes a primary winding and a secondary winding. The switching device is connected between the direct current power source and the primary winding. The switching control circuit controls the switching device to be in the non-conductive state after the switching device is set in the conductive state during first conductive time and further controls the switching device to be in the conductive state during second conductive time after one of the voltages of the primary winding and the secondary winding excess the predetermined value and then to be in the non-conductive state.

## Description

### BACKGROUND OF THE INVENTION

The present invention relates to a high-voltage pulse generating circuit which is capable of providing a high-voltage pulse.

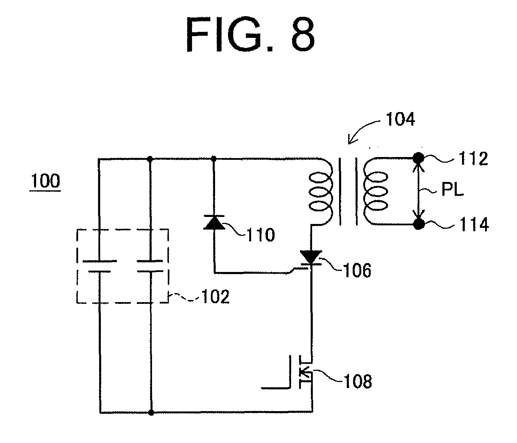

Fig. 8 shows a high-voltage pulse generating circuit 100 which is disclosed in Japanese Patent Publication Application No. 2005-295667. The high-voltage pulse generating circuit 100 is designed to provide a high-voltage pulse for generating plasma. As shown in Fig. 8, the high-voltage pulse generating circuit 100 includes a direct current power source 102, an inductor 104, a first semiconductor switch 106, a second semiconductor switch 108 and a diode 110. The inductor 104, the first semiconductor switch 106 and the second semiconductor switch 108 are connected in series between the ends of the direct current power source 102. One end of the inductor 104 is connected to the anode of the first semiconductor switch 106, and the other end of the inductor 104 is connected to the cathode of the diode 110. The anode of the diode 110 is connected to the gate of the first semiconductor switch 106.

When the second semiconductor switch 108 is turned on and in the conductive state, the first semiconductor switch 106 is also in the conductive state. Consequently, voltage of the direct current power source 102 is applied to the inductor 104, so that induction energy is stored in the inductor 104. Then, the second semiconductor switch 108 is turned off, and the first semiconductor switch 106 is turned off rapidly. Thus, a high-voltage pulse PL is generated in the inductor 104, and outputted therefrom through output terminals 112, 114.

However, the above Publication provides no description about decreasing the pulse width of the high-voltage pulse generated by the high-voltage pulse generating circuit 100. Since the controlling for the pulse width of the high-voltage pulse solely depends on the characteristics of each circuit element, the pulse width cannot be decreased in the high-voltage pulse generating circuit 100.

The present invention is directed to a high-voltage pulse generating circuit which is capable of providing a high-voltage pulse whose width is relatively narrow.

### SUMMARY OF THE INVENTION

In accordance with the present invention, a high-voltage pulse generating circuit includes a direct current power source, a transformer, a switching device and a switching control circuit. The transformer includes a primary winding and a secondary winding. The switching device is connected between the direct current power source and the primary winding. The switching control circuit controls the switching device to be in the non-conductive state after the switching device is set in the conductive state during first conductive time and further controls the switching device to be in the conductive state during second conductive time after one of the voltages of the primary winding and the secondary winding pass the predetermined value and to be in the non-conductive state.

Other aspects and advantages of the invention will become apparent from the following description, taken in conjunction with the accompanying drawings, illustrating by way of example the principles of the invention.

### BRIEF DESCRIPTION OF THE DRAWINGS

The invention together with objects and advantages thereof, may best be understood by reference to the following description of the presently preferred embodiments together with the accompanying drawings in which:
Fig. 1 is a circuit diagram showing a high-voltage pulse generating circuit 1 according to a first preferred embodiment of the present invention;
Fig. 2 is a waveform diagram of a pulse generated by the high-voltage pulse generating circuit 1 of Fig. 1;
Fig. 3 is a circuit diagram showing a high-voltage pulse generating circuit 1A according to a second preferred embodiment of the present invention;
Fig. 4 is a waveform diagram of a pulse generated by the high-voltage pulse generating circuit 1A of Fig. 3;
Fig. 5 is a circuit diagram showing a high-voltage pulse generating circuit 1C according to a third preferred embodiment of the present invention;
Fig. 6 is a waveform diagram of a pulse generated by the high-voltage pulse generating circuit 1C of Fig. 5;
Fig. 7 is a circuit diagram showing a high-voltage pulse generating circuit 1B according to an another embodiment of the present invention; and
Fig. 8 is a circuit diagram showing the high-voltage pulse generating circuit 100 according to the background art.

### DETAILED DESCRIPTION OF THE PREFERRED EMBODIMENTS

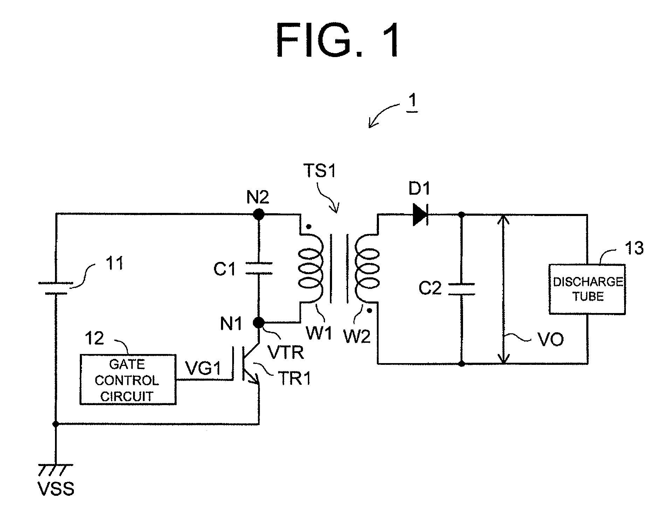

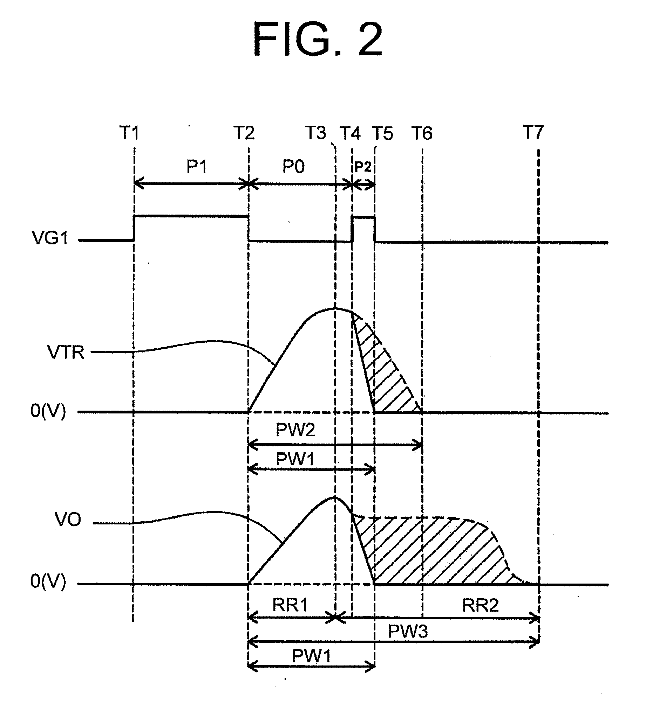

The following will describe a high-voltage pulse generating circuit according to a first preferred embodiment of the present invention with reference to Figs. 1 and 2. Fig. 1 is a circuit diagram of the high-voltage pulse generating circuit 1 according to the first preferred embodiment of the present invention. The high-voltage pulse generating circuit 1 includes a direct current power source 11, a gate control circuit 12, a transformer TS1, a transistor TR1, a capacitor C1, a capacitor C2, a diode D1 and a discharge tube 13. The gate control circuit 12 serves as a switching control circuit, and the capacitor C1 serves as a first capacitor. The transformer TS1 includes a primary winding W1 and a secondary winding W2 and is of flyback type. According to the first preferred embodiment of the present invention, the turn ratio between the primary winding W1 and the secondary winding W2 is one to ten. The transistor TR1 serves as a switching device, such as an insulated gate bipolar transistor (IGBT) or a metal-oxide-semiconductor field-effect transistor (MOSFET). The high-voltage pulse generating circuit 1 is adopted to generate at the discharge tube 13 plasma utilized for cleaning a semiconductor substrate surface or a glass substrate surface, or producing ozone to purify exhaust gas, deodorize and sterilize.

A node N2 connected to the end of the primary winding W1 on the dot side thereof is connected to the positive electrode of the direct current power source 11, and a node N1 connected to the end of the primary winding W1 on the non-dot side thereof is connected to the collector of the transistor TR1. The capacitor C1 is connected between the nodes N1 and N2. The gate control circuit 12 is connected to the gate of the transistor TR1 for applying a gate voltage VG1. The emitter of the transistor TR1 is connected to the negative electrode of the direct current power source 11 and a ground voltage VSS. The ground voltage VSS serves as low-level reference potential.

A node connected to the secondary winding W2 on the dot side thereof is connected to one end of the discharge tube 13, and a node connected to the secondary winding W2 on the non-dot side thereof is connected to the other end of the discharge tube 13 through the diode D1. The capacitor C2 and the discharge tube 13 are connected to each other in parallel.

The following will describe an operation of the high-voltage pulse generating circuit 1 with reference to the waveform diagram of Fig. 2. The waveform of voltage VTR in Fig. 2 represents the voltage at the node N1. The waveform of voltage VO in Fig. 2 represents the output voltage at the secondary winding W2 of the transformer TS1 under a condition where the discharge tube 13 connected to the high-voltage pulse generating circuit 1 is deemed to be a resistance load. As shown in Fig. 2, the gate voltage VG1 is set at high level at time T1, and the transistor TR1 is switched to be in the conductive state. Thus, a power supply voltage VCC of the direct current power source 11 serving as high-level reference potential is applied to the transformer TS1. The current flowing through the primary winding W1 increases at a constant gradient VCC/L1, wherein L1 represents the inductance of the primary winding W1.

The gate voltage VG1 is at low level at time T2, and the transistor TR1 is switched to be in the non-conductive state. Then, the current flowing through the primary winding W1 is shut off, and induced electromotive force is generated, accordingly, so that the voltage VTR at the node N1 and the voltage VO applied to the discharge tube 13 are increased rapidly. The length of time period between the times T1 and T2 during which the transistor TR1 is in the conductive state for the first time will be referred to as first conductive time P1. The value of the first conductive time P1 is set as desired in accordance with the turn ratio of the transformer TS1 and the inductance of the primary winding W1.

The voltage VTR and the voltage VO reach the respective peak levels at time T3. Since the turn ratio of the transformer TS1 is 1 to 10, in the case where the peak level of the voltage VTR is, for example, 1 kV, the peak level of the voltage VO is 10 kV.

At time T4, after the voltages VTR and VO excess the respective peak levels, the gate voltage VG1 is set at high level again, so that the transistor TR1 is switched to be in the conductive state. Therefore, the energy stored in the transformer TS1 is released through the transistor TR1, so that the voltages VTR and VO are rapidly dropped as indicated by the solid line in Fig. 2. The length of time period between the times T2 and T4 during which the transistor TR1 is in the non-conductive state will be referred to as non-conductive time P0. The value of the non-conductive time P0 may be previously set at any suitable time that is close to a length of time period while the voltages VTR and VO start rising at the time T2 and reach the respective peak levels at the time T3. The peak level of the voltage VO can be adjusted by the voltage of the direct current power source 11 and the first conductive time P1, as well as the non-conductive time P0. The length of time period between the times T2 and T3, which is determined by LC resonance between the primary winding W1 and the capacitor C1, may be previously calculated using the inductance L1 of the primary winding W1 and the capacitance of the capacitor C1.

The voltages VTR and VO are dropped to 0 volt at time T5 and, therefore, the energy stored in the transformer TS1 is released completely as indicated by the solid line in Fig. 2. Then, the gate voltage VG1 is set at low level, and the transistor TR1 is switched to be in the non-conductive state. Thus, one cycle pulse generating operation of the high-voltage pulse generating circuit 1 is completed. The length of time period between the times T4 and T5 during which the transistor TR1 is in the conductive state for the second time will be referred to as second conductive time P2. The value of the second conductive time P2 may be previously determined appropriately in accordance with the time required for releasing of the energy.

The following will describe advantageous effects of the high-voltage pulse generating circuit 1 according to the first preferred embodiment of the present invention. According to the conventional high-voltage pulse generating circuit 1, the transistor corresponding to the transistor TR1 of Fig. 1 is maintained in the non-conductive state during the second conductive time P2. In this case, the voltages VTR and VO are gradually decreased, as indicated by the dotted line in Fig. 2, and reach 0 volt at time T6.

Meanwhile, according to the high-voltage pulse generating circuit 1 of the present invention, the transistor TR1 is switched to be in the conductive state during the second conductive time P2. In this case, the voltages VTR and VO are rapidly decreased from the time T4, as indicated by the solid line in Fig. 2, and reach 0 volt at the time T5. Therefore, the pulse width of the voltage VTR is narrowed from pulse width PW2 to pulse width PW1 while having the peak level at the time T3, and also the pulse width of the voltage VO is narrowed from pulse width PW3 to the pulse width PW1 while having the peak level at the time T3. This makes the fall period of the voltages VTR and VO indicated by shaded area in Fig. 2 to be shortened.

In generating plasma at the discharge tube 13, the voltages VTR and VO in voltage rising time RR1 or between the times T2 and T3, are effective to produce plasma. On the other hand, the voltages VTR and VO in voltage falling time RR2 or between the times T3 and T7, are not effective for production of plasma and such voltages become heat loss. According to the first preferred embodiment of the present invention, the shaded region in Fig. 2 corresponding to the voltage falling time RR2 may be reduced thereby to decrease the amount of heating due to the heat loss. This makes possible downsizing of a plasma generating device and saving of electric power for plasma generation.

According to the first preferred embodiment of the present invention, the pulse width is narrowed from the pulse width PW3 to the pulse width PW1, that is about 30% reduction of the width. Since the pulse density may be increased by continuously producing pulses, the performance of the high-voltage pulse generating circuit 1 is improved.

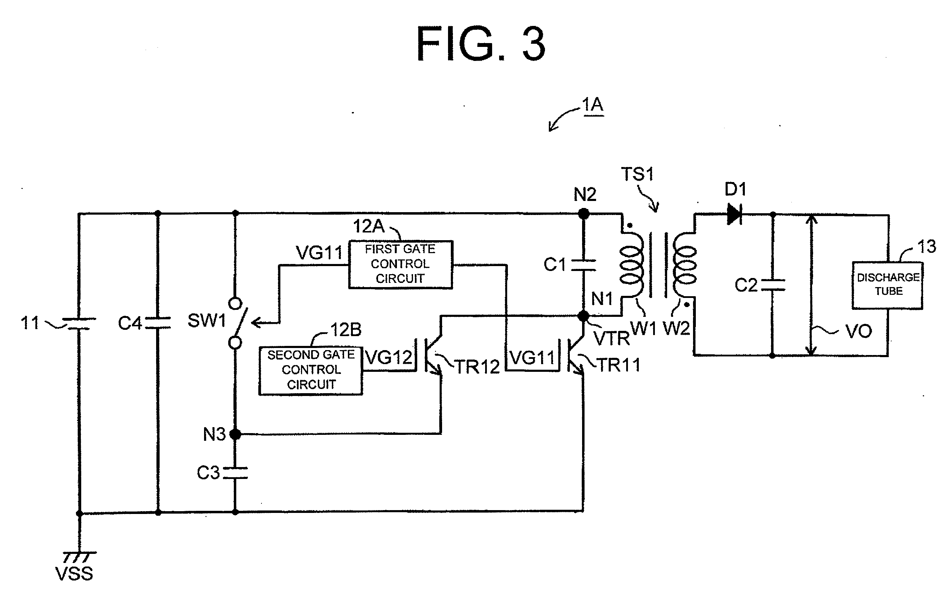

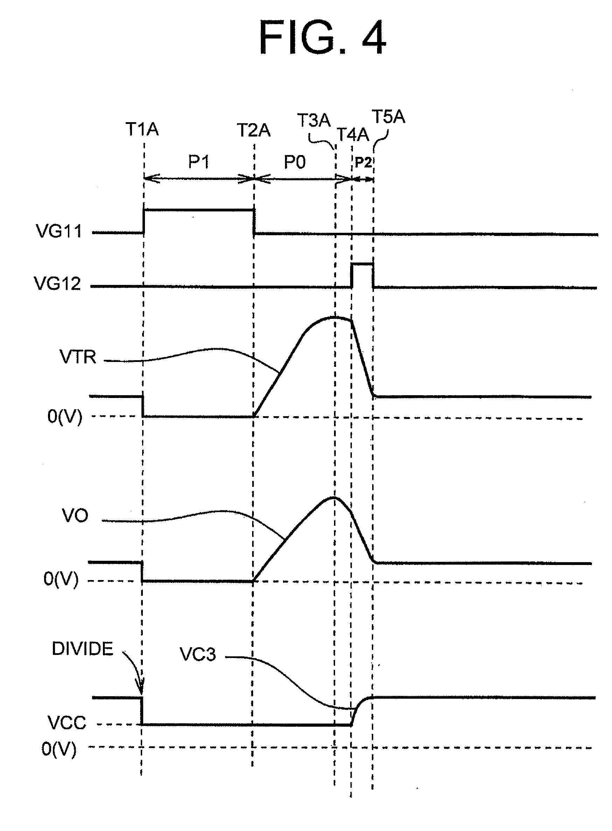

The following will describe a high-voltage pulse generating circuit 1A according to the second preferred embodiment of the present invention with reference to Figs. 3 and 4. The high-voltage pulse generating circuit 1A includes transistors TR11 and TR12 which are an insulated gate bipolar transistor (IGBT), a first gate control circuit 12A, a second gate control circuit 12B, a capacitor C3, a capacitor C4 and a switch SW1 in addition to the structure of the high-voltage pulse generating circuit 1 of the first preferred embodiment.

Each of the transistors TR11 and TR12 serves as a switching device. The transistor TR11 serves as a first switching device, and the transistor TR12 serves as a second switching device. The switch SW1 serves as a third switching device. Each of the first gate control circuit 12A and the second gate control circuit 12B serves as a switching control circuit. The capacitor C3 serves as a second capacitor, and the capacitor C4 serves as a third capacitor.

The first gate control circuit 12A is connected to the gate of the transistor TR11 for applying a gate voltage VG11 to the gate. The collector of the transistor TR12 is connected to the node N1, the emitter of the transistor TR12 is connected to a node N3 and the gate of the transistor TR12 is connected to the second gate control circuit 12B. The second gate control circuit 12B outputs a gate voltage VG12. One end of the capacitor C3 as a first end is connected to the emitter of the transistor TR11, negative electrode of the direct current power source 11 and the ground voltage VSS, and the other end of the capacitor C3 as a second end is connected to the node N3. One end of the switch SW1 is connected to the node N2 and the positive electrode of the direct current power source 11, and the other end of the switch SW1 is connected to the node N3. The capacitor C4 and the direct current power source 11 are connected to each other in parallel. The rest of the structure of the high-voltage pulse generating circuit 1A is substantially the same as that of the high-voltage pulse generating circuit 1 of the first preferred embodiment and, therefore, the description thereof will be omitted.

The following will describe the operation of the high-voltage pulse generating circuit 1A with reference to the waveform diagram of Fig. 4. The waveform of voltage VO in Fig. 4 represents the voltage of the transformer TS1 at the secondary winding W2 under a no-load condition where the discharge tube 13 is not connected to the high-voltage pulse generating circuit 1A. The gate voltage VG11 is set at high level at time T1A, and the transistor TR11 and the switch SW1 are switched to be in the conductive state and energy begins to be stored in the transformer TS1. Part of the energy stored in the capacitor C3 is allocated to the capacitor C4 so that the voltages of the capacitors C3 and C4 become substantially the same, which is as much as the power supply voltage VCC.

The gate voltage VG11 is set at low level at time T2A, and the transistor TR11 and the switch SW1 are switched to be in the non-conductive state. Then, the voltage VTR at the node N1 and the voltage VO applied to the discharge tube 13 are increased rapidly due to the induced electromotive.

The voltages VTR and VO reach their respective peak levels at time T3A. At time T4A, after the voltages VTR and VO excess their respective peak levels, the gate voltage VG12 is set at high level, and the transistor TR12 is switched to be in the conductive state. In this case, the switch SW1 is turned off, a current path is formed from the transformer TS1 to the capacitor C3 through the transistor TR12. The energy stored in the transformer TS1 is transferred to the capacitor C3 through the transistor TR12, which causes the voltages VTR and VO to be dropped rapidly. The voltage VC3 of the capacitor C3 is increased from the power supply voltage VCC depending on the amount of the energy transferred from the transformer TS1. The increased value of the voltage of the capacitor C3 is determined by various characteristics such as inductance L1 of the primary winding W1, the capacitance of the capacitor C3 or the pulse recurrence frequency of the pulse generating operation in the high-voltage pulse generating circuit 1.

When releasing of the energy from the transformer TS1 is completed, the gate voltage VG12 is set at low level at time T5A, and the transistor TR12 is switched to be in the non-conductive state. Thus, the pulse generating operation of the high-voltage pulse generating circuit 1A is completed.

The following will describe the first advantageous effect of the high-voltage pulse generating circuit 1A according to the second preferred embodiment of the present invention. According to the high-voltage pulse generating circuit 1A, energy released from the transformer TS1 may be recovered to be stored in the capacitor C3 during the second conductive time P2 or the time between the times T4A and T5A when the transistor TR12 is switched to be in the conductive state. Thus, energy loss in the operation of the high-voltage pulse generating circuit 1A may be reduced.

The following will describe the second advantageous effect of the high-voltage pulse generating circuit 1A according to the second preferred embodiment. According to the high-voltage pulse generating circuit 1A, the switch SW1 is turned on during the first conductive time P1 or the time between the times T1A and T2A, so that part of the energy stored in the capacitor C3 is allocated to the capacitor C4 and the energy stores of the capacitors C3 and C4 becomes substantially the same. During the second conductive time P2 or the time between the times T4A and T5A, the transistor TR12 is switched to be in the conductive state and the energy stored in the transformer TS1 is transferred to the capacitor C3. The voltage VC3 of the capacitor C3 is increased from the power supply voltage VCC depending on the amount of the energy transferred from the transformer TS1. In the high-voltage pulse generating circuit 1A, the transistor TR12 is an insulated gate bipolar transistor (IGBT) having a unidirectional characteristic. Thus, current path is prevented from being formed in the reverse direction to the current path formed from the direct current power source 11 through the primary winding W1, the transistor TR12 and the capacitor C3, and the voltage VC3 of the capacitor C3 is raised from the power supply voltage VCC and then maintained.

Therefore, in the case where the transistor TR12 is maintained in the conductive state even elapsed after the time T5A when energy releasing from the primary winding W1 is completed, current through the primary winding W1 during the second conductive time P2 is prevented from flowing, so that means the setting the length of the second conductive time P2 is eased. More specifically, the second conductive time P2 may be set to end anytime before the next high-voltage pulse generating operation starts or before the gate voltage VG11 is set at the high level. Thus, stable operating margin of the second gate control circuit 12B may be broader.

The following will describe the third advantageous effect of the high-voltage pulse generating circuit 1A according to the second preferred embodiment. In the high-voltage pulse generating circuit 1 A, the transistors TR11, TR12 are connected to the primary winding W1 in series, respectively. When the transistor TR11 is switched to be in the conductive state during the first conductive time P1, the transformer TS1 stores energy. The energy stored in the transformer TS1 is released by maintaining the transistor TR12 in the conductive state during the second conductive time P2. Thus, store and release of energy can be effected by different transistors. Therefore, in the case where the time interval between the first conductive time P1 and the second conductive time P2 or the length of the non-conductive time P0 is relatively narrow, switching operation can be performed reliably regardless of the switching speed of the transistors.

In the second preferred embodiment, the transistor TR12 is an insulated gate bipolar transistor (IGBT) which has the unidirectional characteristic. Alternatively, the transistor TR12 may be a bidirectional device, such as a metal-oxide-semiconductor field-effect transistor (MOSFET). In this structure, the voltage or current of the capacitor C3 should be detected, and the gate voltage VG12 is set at low level by the second gate control circuit 12B before starting the energy stored in the capacitor C3 returned to the transformer TS1, so that the transistor TR12 is turned to be in the non-conductive state. Therefore, the current path of the capacitor C3 can be prevented from being formed in the reverse direction after the capacitor C3 reaches the peak levels.

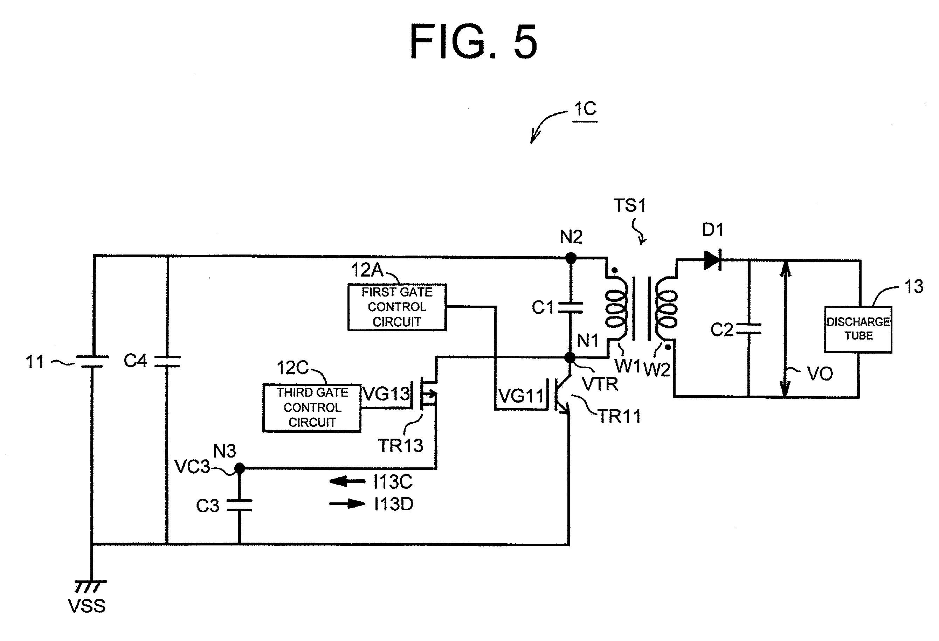

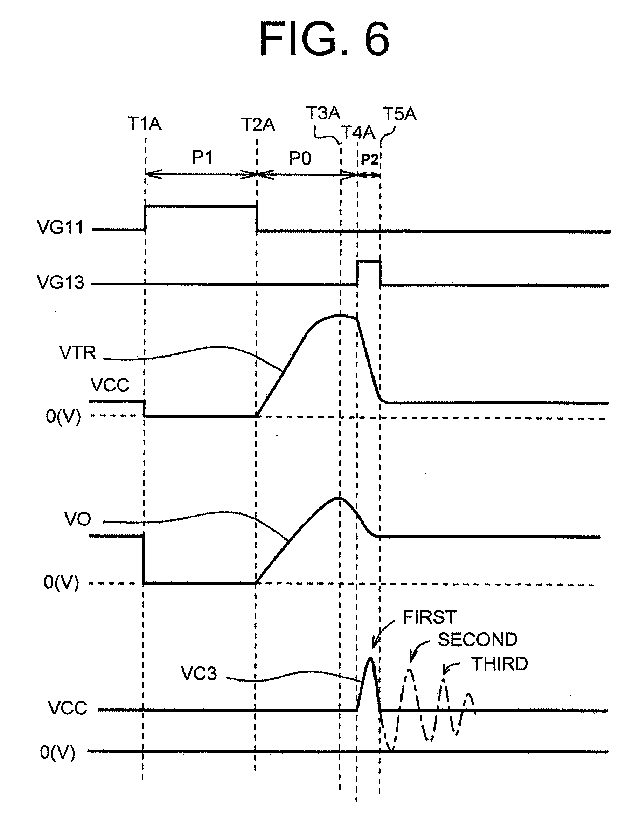

The following will describe a high-voltage pulse generating circuit 1C according to the third preferred embodiment of the present invention with reference to Figs. 5 and 6. The high-voltage pulse generating circuit 1C dispenses with the switch SW1 of the second preferred embodiment and includes a transistor TR13 in addition to the structure of the high-voltage pulse generating circuit 1A of the second preferred embodiment. The transistor TR13 corresponds to the transistor TR12 of the second preferred embodiment and is a metal-oxide-semiconductor field-effect transistor (MOSFET) serving as a bidirectional switch.

Each of the transistors TR11 and TR13 serves as a switching device. The transistor TR11 serves as a first switching device, and the transistor TR13 serves as a second switching device. Each of the first gate control circuit 12A and the third gate control circuit 12C serves as a switching control circuit. The capacitor C3 serves as a second capacitor, and the capacitor C4 serves as a third capacitor.

The drain of the transistor TR13 is connected to the node N1, the source of the transistor TR13 is connected to the node N3, and the gate of the transistor TR 13 is connected to the third gate control circuit 12C. The third gate control circuit 12C outputs a gate voltage VG13. The rest of the structure of the high-voltage pulse generating circuit 1C is substantially the same as that of the high-voltage pulse generating circuit 1A of the second preferred embodiment and, therefore, the description thereof will be omitted.

The following will be describe the operation of the high-voltage pulse generating circuit 1C with reference to the waveform diagram of Fig. 6. The waveform of voltage VO in Fig. 6 represents the voltage of the transformer TS1 at the secondary winding W2 under a no-load condition where the current flow from the high-voltage pulse generating circuit 1C to the discharge tube 13 is deemed to be very low. As shown in Fig. 6, the gate voltage VG11 is set at high level at the time T1A, and the transistor TR11 is turned to be in the conductive state. Thus, the transformer TS1 stores energy. At this time, the voltage VC3 of the capacitor C3 is maintained to a voltage close to the power supply voltage VCC. The gate voltage VG11 is set at low level at the time T2A, and the transistor TR11 is switched to be in the non-conductive state. Then, the voltage VTR at the node N1 and the voltage VO applied to the discharge tube 13 are increased rapidly due to the induced electromotive.

The voltages VTR and VO reach the respective peak levels at the time T3A. At time T4A after the voltages VTR and VO excess the respective peak levels, the gate voltage VG13 is set at high level, and the transistor TR13 is switched to be in the conductive state. In this case, a current path is formed from the transformer TS1 to the capacitor C3 through the transistor TR13. The energy stored in the transformer TS1 is transferred to the capacitor C3 through the transistor TR13, which causes the voltage VTR to be dropped rapidly to a voltage close to the voltage of the capacitor C3 and the voltage VO also to be dropped rapidly.

The voltage VC3 of the capacitor C3 is alternatively increased and decreased according to the resonance frequency f (f = 1/2 π √ (L1 * C31)) which is determined by the inductance L1 of the primary winding W1 and the capacitance C31 of the capacitor C3. Specifically, a current flowing in a direction from the transformer TS1 to the capacitor C3 is referred to as a current I13C, and a current flowing in the opposite direction to the current I13C is referred to as a current I13D as shown in Fig. 5. The current I13C flows to the capacitor C3, so that the voltage VC3 of the capacitor C3 is increased from the power supply voltage VCC and reach the peak level. Subsequently, the current I13D flows from the capacitor C3, so that the energy stored in the capacitor C3 is transferred to the primary winding W1 to be reduced. The gate voltage VG13 is set at low level at the time T5A when the voltage VC3 becomes the same as the power supply voltage VCC, and the transistor TR13 is switched to be in the non-conductive state. The transistor TR13 is switched to be in the non-conductive state at a time when the voltage VC3 is decreased after the voltage VC3 is increased. At the time during the second conductive time P2, the current I13D flows in the opposite direction to the current I13C and the energy stored in the capacitor C3 is released during the second conductive time P2. The current I13D flows back to the capacitor C4 through the primary winding W1, and the energy stored in the capacitor C4. Thus, one cycle pulse generating operation of the high-voltage pulse generating circuit 1C is completed.

The time T5A or the second conductive time P2 may be set a predetermined time by a periodic waveform of the voltage VC3 according to the resonance frequency f (f = 1/2 π √ (L1 * C31)). The time T5A may be set a time when a device (not shown) used for monitoring the voltage VC3 of the capacitor C3 detects that the voltage VC3 is decreased back to the power supply voltage VCC after the voltage VC3 is once increased from the power supply voltage VCC, and then the transistor TR13 may be turned off at the time T5A. Or, the time T5A may also be set a time when a device (not shown) used for monitoring the voltage VTR detects that the voltage is decreased back to the power supply voltage VCC after the voltage VTR is once increased from the power supply voltage VCC and then the transistor TR13 is turned off. The voltage VC3 has a waveform relative to the power supply voltage VCC according to the resonance frequency f, and the level of the waveform of the voltage VC3 indicated by solid line and dot line in Fig.6 is gradually reduced. According to the third preferred embodiment, the time T5A is set at a time when the voltage VC3 is decreased after the voltage VC3 excess their first peak level.

The following will describe advantageous effects of the high-voltage pulse generating circuit 1C according to the third preferred embodiment of the present invention. The energy released from the transformer TS1 is once stored in the capacitor C3 during the second conductive time P2 or the time between the time T4A and the time T5A when the transistor TR 13 is switched to be in the conductive state. Then, the transistor TR13 is switched to be in the non-conductive state at a time when the energy stored in the capacitor C3 is transferred to the primary winding W1 again due to LC resonance, so that the energy stored in the capacitor C3 is transferred and stored in the capacitor C4 through the primary winding W1. Thus, energy loss in the operation of the high-voltage pulse generating circuit 1C may be reduced.

Since the transistor TR13 is a bidirectional switch, such as a metal-oxide-semiconductor field-effect transistor (MOSFET), the energy may be stored in and released from the capacitor C3 through the transistor TR13.

The present invention is not limited to the above-described embodiments, but may be modified into various alternative embodiments, as exemplified below.

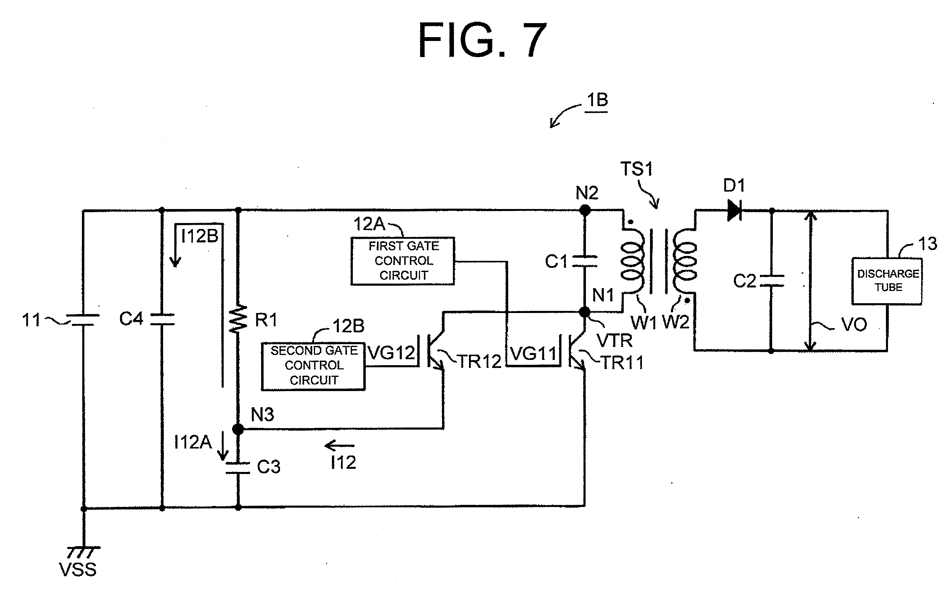

As shown in the high-voltage pulse generating circuit 1B of Fig. 7, a resistance device R1 may be used instead of the switch SW1. Each of the transistors TR11 and TR12 serves as a switching device. The transistor TR11 serves as a first switching device, and the transistor TR12 serves as a second switching device. Each of the first gate control circuit 12A and the second gate control circuit 12B serves as a switching control circuit. The capacitor C3 serves as a second capacitor, and the capacitor C4 serves as a third capacitor.

During the second conductive time P2 when the transistor TR12 is in the conductive state, a current I12 flowing through the transistor TR12 is divided at the node N3 into a current I12A flowing to the capacitor C3 and a current I12B flowing to the capacitor C4. The dividing ratio of the current I12 is determined depending on the resistance of the resistance device R1 such that the current I12A becomes greater than the current I12B in accordance with setting greater the resistance value of the resistance device R1.

According to the above-described embodiments, the values of the non-conductive time P0 and the second conductive time P2 are previously determined appropriately, but the present invention is not limited to such arrangement. The non-conductive time P0 may have a value close to the lengths of time before or after the voltages VTR and VO reach the respective peak levels at the time T3 after they start to rise at the time T2, and may not include a value when the voltages VTR and VO reach the peak level. The value of the non-conductive time P0 may be determined by detecting that at least one of the voltages VTR and VO reaches the corresponding predetermined value near the corresponding peak level. The value of the second conductive time P2 may be determined by detecting that at least one of the voltages VTR and VO is decreased less than corresponding predetermined value.

According to the above-described embodiments, the time T5A is set at a time when the voltage VC3 of the capacitor C3 is decreased after the voltage VC3 of the capacitorC3 excess the first peak level of the waveform of the voltage VC3 of the capacitor C3. Alternatively, the time T5A may be set at a time when the voltage VC3 of the capacitor C3 is decreased after the voltage VC3 of the capacitor C3 excess the second or other peak level.

According to the above-described embodiments, the voltage VC3 of the capacitor C3 is maintained to be near the power supply voltage VCC. Alternatively, the capacitor C3 may be maintained in a state where the capacitor C3 stores no energy.

Application of the high-voltage pulse generating circuits 1 through 1C is not limited to apply to an ozone generating device. A pulse generating device for plasma may be applied to any devices.

A high-voltage pulse generating circuit includes a direct current power source, a transformer, a switching device and a switching control circuit. The transformer includes a primary winding and a secondary winding. The switching device is connected between the direct current power source and the primary winding. The switching control circuit controls the switching device to be in the non-conductive state after the switching device is set in the conductive state during first conductive time and further controls the switching device to be in the conductive state during second conductive time after one of the voltages of the primary winding and the secondary winding excess the predetermined value and then to be in the non-conductive state.

## Claims

1. A high-voltage pulse generating circuit (1,1A, 1B, 1C) comprising:
a direct current power source (11);
a transformer (TS1) including a primary winding (W1) and a secondary winding (W2);
a switching device (TR1, TR11, TR12, TR13) connected between the direct current power source (11) and the primary winding (W1); and
a switching control circuit (12, 12A, 12B, 12C) controlling the switching device (TR1, TR11, TR12, TR13),
**characterized in that** the switching control circuit (12, 12A, 12B, 12C) controls the switching device (TR1, TR11) to be in the non-conductive state after the switching device (TR1, TR11) is set in the conductive state during first conductive time (P1) and further controls the switching device (TR1, TR12, TR13) to be in the conductive state during second conductive time (P2) after one of the voltages (VTR, VO) of the primary winding (W1) and the secondary winding (W2) excess the predetermined value and then to be in the non-conductive state.

2. The high-voltage pulse generating circuit (1, 1A, 1B, 1C) according to claim 1, further comprising a first capacitor (C1) which connected to the primary winding (W1) in parallel.

3. The high-voltage pulse generating circuit (1, 1A, 1 B, 1C) according to claim 1 or 2, wherein the second conductive time (P2) is a time period during which energy stored in the primary winding (W1) is released.

4. The high-voltage pulse generating circuit (1A, 1B, 1C) according to any one of claims 1 through 3, wherein the switching device (TR11, TR12, TR13) is connected to the primary winding (W1) in series and includes a first switching device (TR11) and a second switching device (TR12, TR13) connected to each other in parallel, wherein the switching control circuit (12A, 12B, 12C) controls the first switching device (TR11) to be in the conductive state during the first conductive time (P1) and the second switching device (TR12, TR13) to be in the conductive state during the second conductive time (P2).

5. The high-voltage pulse generating circuit (1A, 1 B, 1 C) according to claim 4, further comprising a second capacitor (C3) connected to low-level reference potential (VSS) at a first end of the second capacitor (C3) and the second switching device (TR12, TR13) at a second end of the second capacitor (C3).

6. The high-voltage pulse generating circuit (1A) according to claim 5, further comprising a third switching device (SW1) connected between the second end of the second capacitor (C3) and high-level reference potential (VCC), wherein the first switching device (TR11) is connected between the primary winding (W1) and the low-level reference potential (VSS), and the second switching device (TR12) is connected between the primary winding (W1) and the second end of the second capacitor (C3), and the switching control circuit (12A, 12B) controls the first switching device (TR11) to be in the conductive state during the first conductive time (P1), the second switching device (TR12) to be in the conductive state during the second conductive time (P2) and the third switching device (SW1) to be in the non-conductive state during the second conductive time (P2).

7. The high-voltage pulse generating circuit (1A) according to claim 6, further comprising a third capacitor (C4) connected to the direct current power source (11) in parallel, wherein the switching control circuit (12A) controls the third switching device (SW1) to be in the conductive state during the first conductive time (P1).

8. The high-voltage pulse generating circuit (1C) according to claim 5, further comprising a third capacitor (C4) connected to the direct current power source (11) in parallel, wherein the first switching device (TR11) is connected between the first winding (W1) and the low-level reference potential (VSS), the second switching device (TR13) is connected between the primary winding (W1) and the second end of the second capacitor (C3), and the switching control circuit (12A) controls the first switching device (TR11) to be in the conductive state during the first conductive time (P1), the second switching device (TR13) to be in the conductive state during the second conductive time (P2) wherein the switching timing from the conductive state of the second conductive time (P2) into the non-conductive state is set based on the period that the energy of the second capacitor (C3) stored during the second conductive time (P2) is released.

9. The high-voltage pulse generating circuit (1B) according to claim 5, further comprising a resistance device (R1) connected between the second end of the second capacitor (C3) and the high-level reference potential (VCC) and a third capacitor (C4) connected to the direct current power source (11) in parallel, wherein the first switching device (TR11) is connected between the primary winding (W1) and the low-level reference potential (VSS), the second switching device (TR12) is connected between the primary winding (W1) and the second end of the second capacitor (C3), and the switching control circuit (12A, 12B) controls the first switching device (TR11) to be in the conductive state during the first conductive time (P1), the second switching device (TR12) to be in the conductive state wherein the current flows through the resistance device (R1) into the third capacitor (C4) during the second conductive time (P2).

10. The high-voltage pulse generating circuit (1, 1A, 1 B, 1 C) according to any one of claims 1 through 9, further comprising a discharge tube (13) connected to the secondary winding (W2).
